# EUROPEAN PATENT SPECIFICATION

(11) **EP 0 925 513 B1**
(45) Date of publication and mention of the grant of the patent: **24.03.2010**
(21) Application number: 97941593.2
(22) Date of filing: 12.09.1997
(51) Int. Cl.: G01R 31/316, G01R 1/073

(54) **WAFER SCALE HIGH DENSITY PROBE ASSEMBLY, APPARATUS FOR USE THEREOF AND METHODS OF FABRICATION THEREOF**
HOCHDICHTE SONDENANORDNUNG FÜR WAFERBEREICH, GERÄT ZU DESSEN BENUTZUNG UND HERSTELLUNGSVERFAHREN DAZU
ENSEMBLE SONDE A HAUTE DENSITE A L'ECHELLE D'UNE TRANCHE, SON APPAREIL D'UTILISATION ET SES PROCEDES DE FABRICATION

(30) Priority: 13.09.1996 US 26088
(43) Date of publication of application: 30.06.1999
(73) Proprietor: International Business Machines Corporation, Armonk, NY 10504 (US)
(72) Inventor: BEAMAN, Brian, Samuel, Apex, NC 27502 (US); FOGEL, Keith, Edward, Mohegan Lake, NY 10547 (US); LAURO, Paul Alfred, Apartment D, Nanuet, NY 10954 (US); SHIH, Da-Yuan, Poughkeepsie, NY 12603 (US)
(74) Representative: Burt, Roger James
(86) International application number: PCT/US1997/016264
(87) International publication number: WO 1998/011449

(56) References cited:
- EP-A- 0 593 966
- DE-A- 3 337 915
- US-A- 5 177 439
- US-A- 5 225 777
- US-A- 5 338 223

## Description

### FIELD OF THE INVENTION

The present invention is directed to structures useful as probes for testing of electrical interconnections to integrated circuit devices and other electronic components and particularly to testing of integrated circuit devices with rigid interconnection pads and multi-chip module packages with high density interconnection pads.

### BACKGROUND OF THE INVENTION

Integrated circuit (IC) devices and other electronic components are normally tested to verify the electrical function of the device and certain devices require high temperature burn-in testing to accelerate early life failures of these devices. Wafer probing is typically done on a single chip site at temperatures ranging from 25C - 125C while burn-in is typically done on diced and packaged chips at temperatures ranging from 80C to 140C Wafer probing and IC chip burn-in at elevated temperatures of up to 200C has several advantages and is becoming increasingly important in the semiconductor industry. Simultaneous testing of multiple chips on a single wafer has obvious advantages for reducing costs and increasing production thruput and is a logical step towards testing and burn-in of an entire wafer.

The various types of interconnection methods used to test these devices include permanent, semi-permanent, and temporary attachment techniques. The permanent and semi-permanent techniques that are typically used include soldering and wire bonding to provide a connection from the IC device to a substrate with fan out wiring or a metal lead frame package. The temporary attachment techniques include rigid and flexible probes that are used to connect the IC device to a substrate with fan out wiring or directly to the test equipment.

The permanent attachment techniques used for testing integrated circuit devices such as wire bonding to a leadframe of a plastic leaded chip carrier are typically used for devices that have low number of interconnections and the plastic leaded chip carrier package is relatively inexpensive. The device is tested through the wire bonds and leads of the plastic leaded chip carrier and plugged into a test socket. If the integrated circuit device is defective, the device and the plastic leaded chip carrier are discarded.

The semi-permanent attachment techniques used for testing integrated circuit devices such as solder ball attachment to a ceramic or plastic pin grid array package are typically used for devices that have high number of interconnections and the pin grid array package is relatively expensive. The device is tested through the solder balls and the internal fan out wiring and pins of the pin grid array package that is plugged into a test socket. If the integrated circuit device is defective, the device can be removed from the pin grid array package by heating the solder balls to their melting point. The processing cost of heating and removing the chip is offset by the cost saving of reusing the pin grid array package.

The most cost effective techniques for testing and burn-in of integrated circuit devices provide a direct interconnection between the pads on the device to a probe sockets that is hard wired to the test equipment. Contemporary probes for testing integrated circuits are expensive to fabricate and are easily damaged. The individual probes are typically attached to a ring shaped printed circuit board and support cantilevered metal wires extending towards the center of the opening in the circuit board. Each probe wire must be aligned to a contact location on the integrated circuit device to be tested. The probe wires are generally fragile and easily deformed or damaged. This type of probe fixture is typically used for testing integrated circuit devices that have contacts along the perimeter of the device. This type of probe is also much larger than the IC device that is being tested and the use of this type of probe for high temperature testing is limited by the probe structure and material set.

Another technique used for testing IC devices comprises a thin flex circuit with metal bumps and fan out wiring. The bumps are typically formed by photolithographic processes and provide a raised contact for the probe assembly. The bumps are used to contact the flat or recessed aluminum bond pads on the IC device. An elastomer pad is typically used between the back of the flex circuit and a pressure plate or rigid circuit board to provide compliance for the probe interface. This type of probe is limited to flexible film substrate materials that typically have one or two wiring layers. Also, this type of probe does not provide a wiping contact interface to ensure a low resistance connection.

The aluminum bond pads on a high density IC device are typically rectangular in shape and are recessed slightly below the surface of the passivation layer. If the wiping action of the high density probe is not controlled, the probe contact may move in the wrong direction and short to an adjacent aluminum bond pad or the probe contact may move off of the aluminum bond pad onto the surface of the passivation layer and cause an open connection.

Gold plated contacts are commonly used for testing and burn-in of IC devices. The high temperature test environment can cause diffusion of the base metal of the probe into the gold plating on the surface. The diffusion process creates a high resistive oxide layer on the surface of the probe contact and reduces the probe life.

The position of the probe tips must be controlled to ensure accurate alignment of the probes to the interconnection pads on the IC device. During high temperature burn-in testing, the thermal expansion mismatch between the probe structure and the IC device must be small to ensure that the probe position does not vary significantly over the burn-in temperature range. Thermal expansion mismatch within the probe structure can result in contact reliability problems.

The challenges of probing a single high density integrated circuit device are further multiplied for multi-chip and full wafer testing applications. Probe fabrication techniques and material selection are critical to the thermal expansion and contact alignment considerations. A small difference in the thermal expansion of the substrate, wafer, and probe construction will cause misalignment of the probe tip to the wafer contact pad. Compliance of the probe structure is another critical factor. Slight variations in the wafer metalization, warpage of the wafer, and slight variations in the probe height contribute to the total compliance requirements for the probe structure.

US Patent 5,177,439, issued January 5, 1993 to Liu et al., is directed to fixtures for testing bare IC chips. The fixture is manufactured from a silicon wafer or other substrate that is compatible with semiconductor processing. The substrate is chemically etched to produce a plurality of protrusions to match the I/O pattern on the bare IC chip. The protrusions are coated with a conductive material and connected to discrete conductive fanout wiring paths to allow connection to an external test system. The probe geometry described in this patent does not provide a compliant interface for testing the aluminum bond pads on the IC device and does not provide a wiping contact interface. The substrate used for fabrication of this probe fixture is limited to semiconductor wafers which are relatively expensive. The high density probe with controlled wipe can be fabricated on a variety of inexpensive substrate with the fanout wiring.

IBM patent publication USS,635,846 describes a high density test probe for integrated circuit devices. The probe structure described in this docket uses short metal wires that are bonded on one end to the fan out wiring on a rigid substrate. The wires are encased in a compliant polymer material to allow the probes to compress under pressure against the integrated circuit device. The wire probes must be sufficiently long and formed at an angle to prevent permanent deformation during compression against the integrated circuit device. The probe structure described in this patent does not provide a means of controlling the direction and length of the wiping action of the contact interface.

IBM patent publication US 5.811,982 describes a high density test probe for integrated circuit devices with aluminum bond pads. The probe structure described in this patent does is subject to contact reliability problems due to the thermal expansion mismatch between the metal wire conductor and the elastomer material surrounding the wires. At high temperatures, the elastomer material expands sufficiently to cause an open connection between the metal wire probes and the IC bond pads. Also, after repeated thermal cycles, the ends of the probe wires are sufficiently exposed above the surface of the elastomer material to be deformed during a subsequent contact cycle with the bond pads on an IC device.

The IEEE publication "A Novel Elastomeric Connector for Packaging Interconnections, Testing and Burn-in Applications" by Shih et al. and US-A-5 225 777 also show high density test probes.

### OBJECTS

It is the object of the present invention to provide a probe for testing integrated circuit devices and other electronic components that use bond pads for the interconnection means.

Another object of the present invention is to provide a probe structure that is an integral part of the fan out wiring on the test substrate or other printed wiring means to minimize the electrical conductor length as well as the contact resistance of the probe interface.

A further object of the present invention is to provide a probe with a compliant interface to compensate for slight variations in the rigid bond pad heights on the IC device and variations in the height of the probe contacts.

An additional object of the present invention is to provide a raised probe tip for contacting recessed surfaces on the IC device.

Yet another object of the present invention is to provide a probe with a wiping contact interface where the direction and length of the contact wipe is controllable.

Yet a further object of the present invention is to provide a probe construction that has thermal expansion characteristics that are matched to the IC device to be tested or burned-in at high temperature.

Yet an additional object of the present invention is to provide a probe construction that has high durability and reliability for repeated thermal and mechanical cycling.

Yet another object of the present invention is to provide a probe structure that can be used for single chip or multiple chip wafer testing.

### SUMMARY OF THE INVENTION

According to a first aspect of the invention there is provided a structure as described in claim 1.

According to a second aspect of the invention there is provided an apparatus as described in claim 8.

According to a third aspect of the invention there is a method as described in claim 10.

Including moving the second ends into contact with a workpiece, second ends moving about a reference positions.

### BRIEF DESCRIPTION OF THE DRAWINGS

These and other objects, features, and advantages of the present invention will become apparent upon further consideration of the following detailed description of the invention when read in conjunction with the drawing figures, in which:
FIGURE 1 shows a cross section of an integrated cantilever compliant test probe attached to a substrate and pressed against the aluminum bond pads on an integrated circuit device.
FIGURE 2 is essentially the same as FIGURE 1 with a modified arrangement of the cantilevered flap.
FIGURES 3-6 show the processes used to fabricate the integrated cantilever test probe on a fan out wiring substrate.
FIGURE 7 shows an alternate process used to fabricate the integral cantilever compliant test probe.
FIGURE 8 shows a top view of the preferred embodiment of a integrated cantilever compliant test probe.
FIGURE 10 shows a cross section of an embodiment of the integrated cantilever compliant test probe attached to a substrate and pressed against the aluminum bond pads on an integrated circuit device.
FIGURE 11 shows a top view of an embodiment of the integrated cantilever compliant test probe.
FIGURE 12 shows a cross section of an embodiment of the integrated cantilever complaint test probe attached to a substrate and pressed against the aluminum bond pads on an integrated circuit device.
FIGURE 13 shows a top view of an embodiment of the integrated cantilever compliant test probe.
FIGURE 14 shows a cross section of an example of an integrated cantilever compliant test probe.
FIGURE 15 shows a cross section of an integrated cantilever compliant test probe array for testing multiple IC devices on a single wafer.
FIGURE 16 shows a top view of an integrated cantilever compliant test probe array for testing all of the IC devices on a single wafer.
FIGURE 17 shows various shapes to the elongated conductors such as "S"shaped, curved, piece wire linear or combination thereof.
FIGURE 18 shows spring means for maintaining sheet (20) resiliency spaced apart from surface (12) of substrate (11). The resilient spacers can be springs or are elastomeric material.
FIGURE 19 shows a schematic diagram of a probing apparatus incorporating the probe structures of the present invention.

### DETAILED DESCRIPTION OF THE PREFERRED EMBODIMENT

### Preferred Embodiment

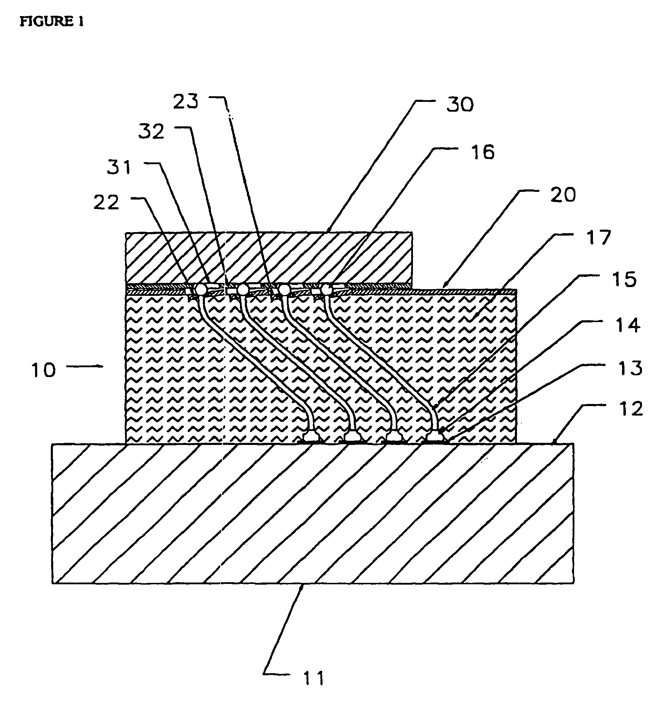

FIGURE 1 shows a cross section of a test substrate (11) and an integrated cantilever compliant test probe (10) according to the present invention. The test substrate (11) provides a rigid base for attachment of the probes (10) and fan out wiring from the high density array of probe contacts to a larger grid of pins or other interconnection means to the equipment used to electrically test the integrated circuit device. The fan out substrate can be made from various materials and constructions including single and multi-layer ceramic with thick or thin film wiring, silicon wafer with thin film wiring, or epoxy glass laminate construction with high density copper wiring. The test probes (10) are attached to the first surface (12) of the substrate (11). The probes are used to contact the bond pads (31), typically aluminum bond pads, on the electronic device, typically an integrated circuit device (30). The bond pads (31) are typically recessed slightly below the surface of the passivation layer (32) of the electronic device (30). The geometry of the integrated cantilever compliant test probe (10) is optimized to provide a wiping contact interface to penetrate the oxides on the surface of the bond pads (31) to provide a low resistance connection.

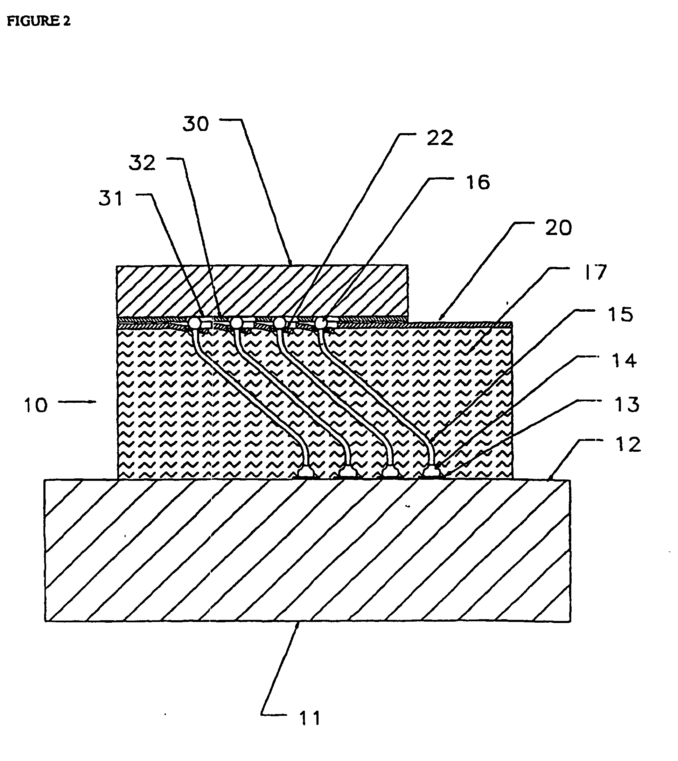

FIGURE 2 is essentially the same as FIGURE 1 with a modified arrangement of the cantilevered flap in the polymer material. The test probe (10) is attached directly to the fan out wiring (13) on the first surface (12) of the substrate (11) to minimize the resistance of the probe interface. The probe geometry is optimized to provide a flexible contact interface that controls the direction and length of the wiping action. The elastomer material (17) preferably surrounding the probes provides an compliant structure and the cantilevered flaps (23) in the thin polymer sheet (18) are used to control the direction and length that the probe tip (16) can wipe against the aluminum bond pads (31) on the IC device (30). The probe tip (16) is bonded to the cantilevered flap (23) using a suitable epoxy material (22). As the high density probe (10) is pressed against the IC device (30), the probe wire (15) and the cantilevered flap (23) rotate and the probe tip (16) slides along the surface of the bond pads (31) of the IC device (30). The probe tip ends (16) move about a reference position that is the position probe tip ends have when the probe tip ends are not pressed against a device under test.

The length of the sliding or wiping action is restricted by the angle and length of the probe wire (15) and the length of the cantilevered flap (23) in the sheet (20). Sheet (20) is preferably of a polymer material.

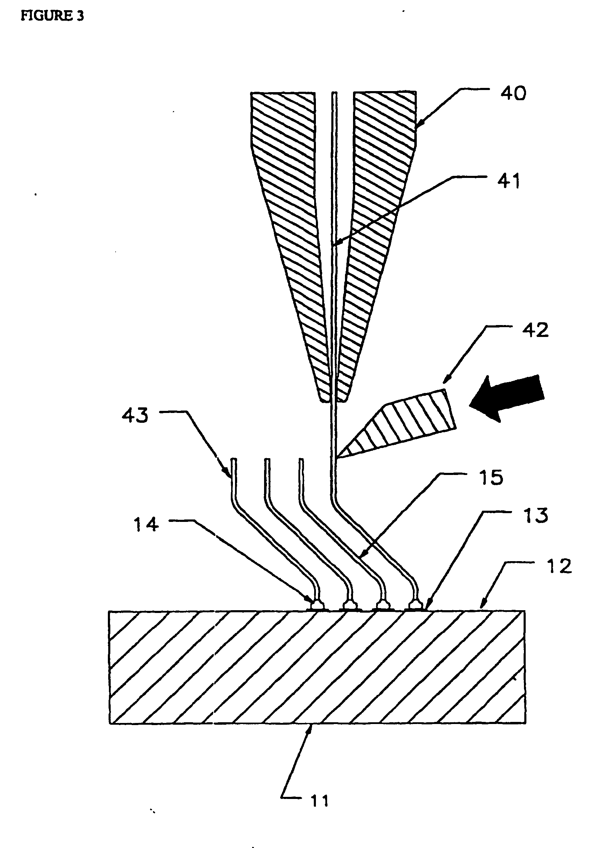

FIGURE 3 shows a process used to fabricate the integrated cantilever compliant test probe. A thermosonic wire bonder tool is used to attach ball bonds (14) to the fan out wiring (13) on the first surface (12) of the rigid substrate (11). The wire bonder tool uses a first ceramic capillary (40) to press the ball shaped end of the bond wire (41) against the first surface (12) of the substrate (11). Compression force and ultrasonic energy are applied through the first capillary (40) tip and thermal energy is applied from the wire bonder stage through the substrate (11) to bond the ball shaped end of the bond wire (41) to the fan out wiring (13) on the first surface (12) of the substrate (11). The bond wire (41) is positioned at an angle and a shear blade (42) is used to sever the bond wire (41) to create an angled segment of wire (15) protruding vertically from the ball bond (14). The movement of the ceramic capillary (40) is controlled during this process to provide a short straight section of the wire (43) that is perpendicular to the surface of the rigid substrate (10).

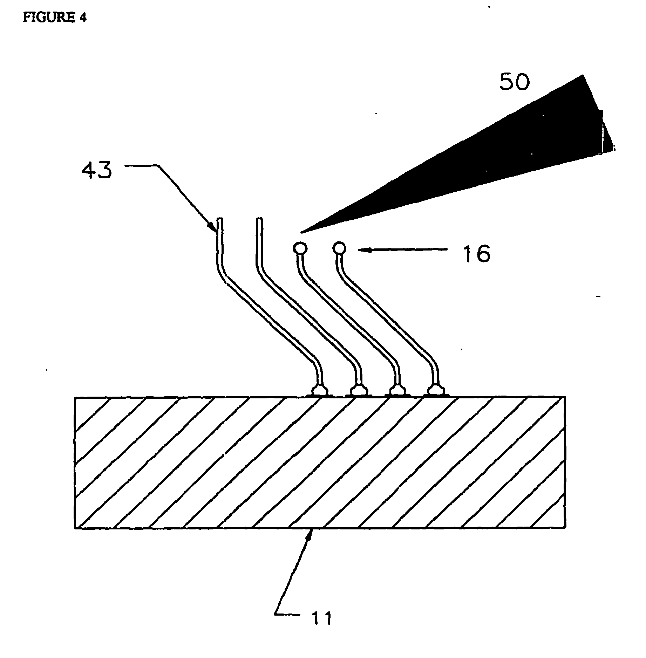

FIGURE 4 shows a laser (50) (preferably an argon ion laser) used to melt the ends of the short straight sections of the wire (15) to create a ball shaped contact (16). The smooth surface of the ball shaped contact (16) is ideal for a wiping interface. The size of the ball shaped contact (16) on the end of the probe is controlled by the laser power density and the alignment of the focal point from the tip of the straight wire section (43). The shape at the end of the wire can be any shaped protuberance such as, for example, a ball with a barbed or pointed end or a shaft pointed end.

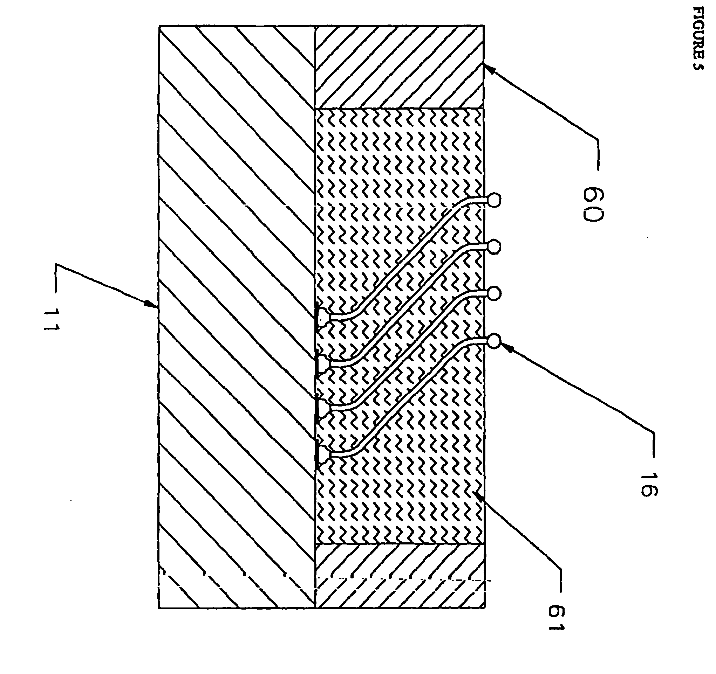

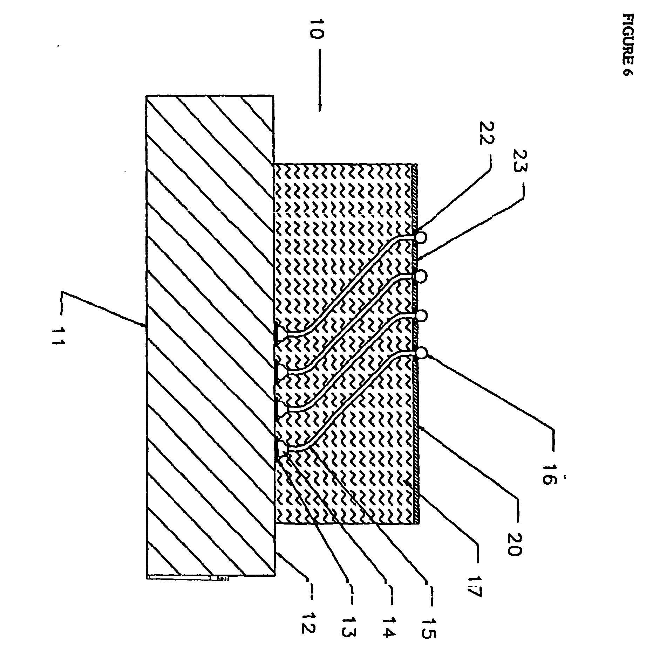

FIGURE 5 shows a casting dam (60) placed around the array of high density probes. The casting dam (60) is used to contain the liquid elastomer (61) until it is cured. A controlled volume of liquid elastomer resin (61) is dispensed into the cavity and allowed to settle out before curing. The height of the elastomer material (61) is controlled so that ball shaped end of the probe (16) is slightly above the surface of the elastomer (61) - Once the elastomer has' cured, the casting dam (60) is removed and a sheet (20) with cantilever flats (23) and corresponding openings is placed over the ball shaped ends (16) of the probes as shown in FIGURE 6. The sheet (20) is preferably a polymer sheet. An epoxy material (22) is applied to the openings in the polymer sheet (20) and cured to bond the probe to the cantilevered flaps (23).

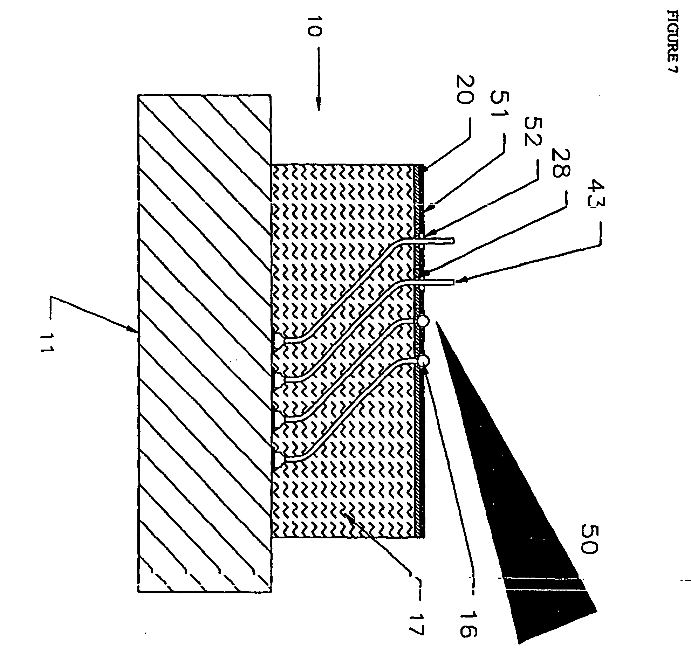

FIGURE 7 shows another process according to the present invention used to fabricate the integral cantilever compliant test probe (10). The sequence of the fabrication process is changed in order to cast and cure the elastomer resin before the laser ball forming process. After the elastomer (17) is cast and cured, a thin polymer sheet (20) with small opening (28) corresponding to the probe locations is place over the straight ends of the probe wires (43). A (preferably thin metal) mask (51) with larger openings (52) corresponding to the probe locations is also placed over the ends of the probe wires (43). After the (preferably argon-ion) laser (50) is used to form the ball shaped (16) ends on the probe wires, the metal mask (51) is removed from the top surface of the probe structure (10). The mask (51) prevents polymer sheet (20) from being exposed to the light of laser (50). The mask (51) can be of any light blocking material such as metal, ceramic, glass, polymer and combinations thereof.

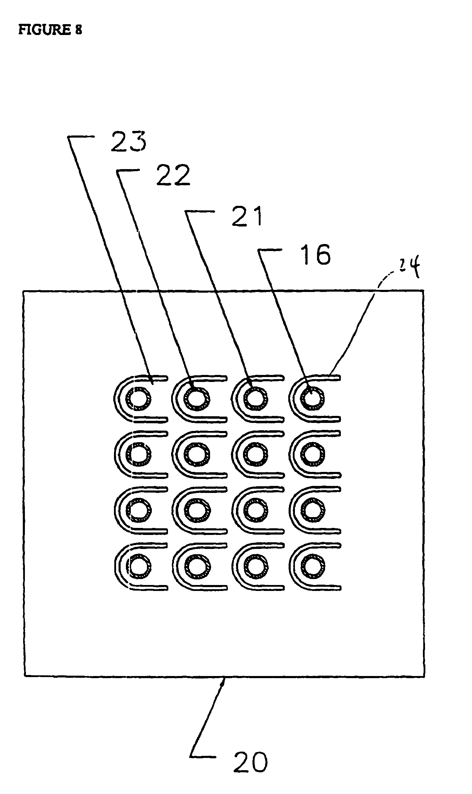

FIGURE 8 shows a top view of the test probe and the cantilevered flaps (23) in the sheet (20) that is attached to the top of the layer of elastomer material (17). Openings (21) in the sheet (20) are aligned with the ball shaped ends (16) of the probes and preferably bonded to the polymer sheet using an epoxy material. The accuracy of the location of the ball shaped probe contacts (16) is determined by the accuracy of the location of the openings (21) in the polymer sheet (20).The sheet (20) material is preferably selected to match the thermal coefficient of expansion (TCE) of the device or other substrate material of the device to be tested at elevated temperatures. Flap (23) is formed by perforation (24) which is "U" shaped in FIGURE 8. Perforation (24) can be any shape such as triangular, a section of a circle, rectangular, polygonal and combinations thereof.

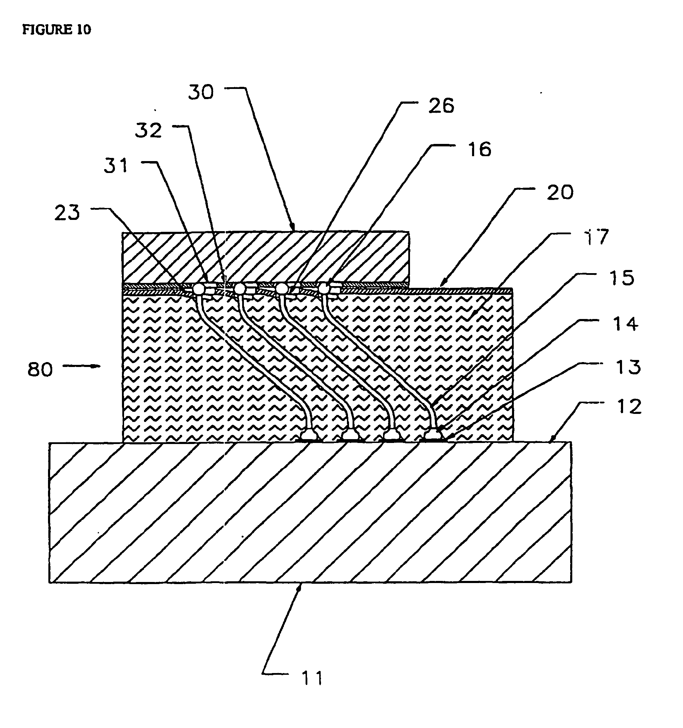

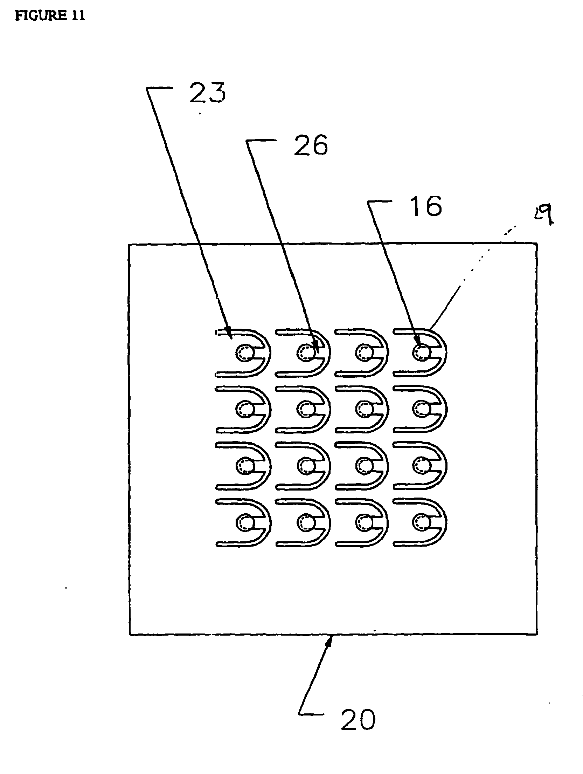

FIGURE 10 shows another embodiment of the integrated cantilever compliant test probe (80). Instead of bonding the probe wire (15) to the cantilevered flaps (23) in the material (20), the embodiment (80) uses a slotted opening (26) in the cantilevered flaps (23) to control the movement of the probe tip (16). The width of the slot (26) in the cantilevered flap (23) is slightly wider than the diameter of the probe wire (15). The narrow width of the slot (26) prevents the ball shaped probe tip (16) from sinking into the soft elastomer material (17) during compression of the probe structure. FIGURE 11 shows a top view of the embodiment of FIGURE 10. Again perforation (29) is shown "U" shaped but can be any shape.

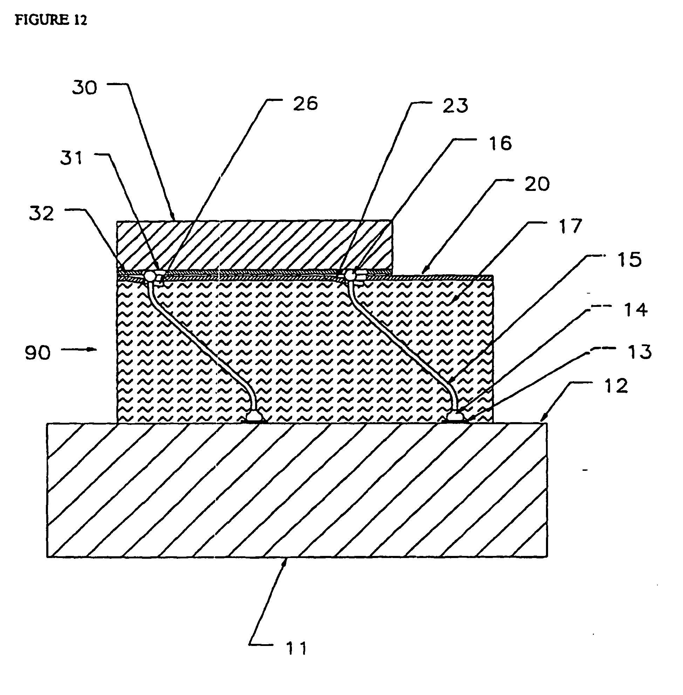

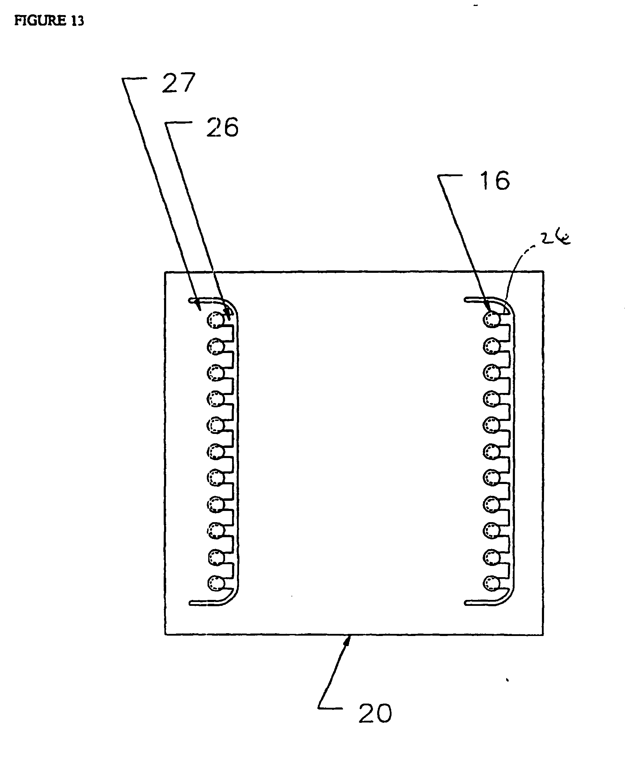

FIGURES 12 and 13 show another embodiment of the integrated cantilever compliant test probe (90). The structure of the embodiment (90) is similar to the embodiment (80) of the test probe of FIGURES 10 and 11. The spacing between the probes in one direction is much farther apart than in the opposite direction. The embodiment (90) uses a single cantilevered flap (27) to control several probe wires. Perforation (22) partially surrounds a group of openings or slots (26).

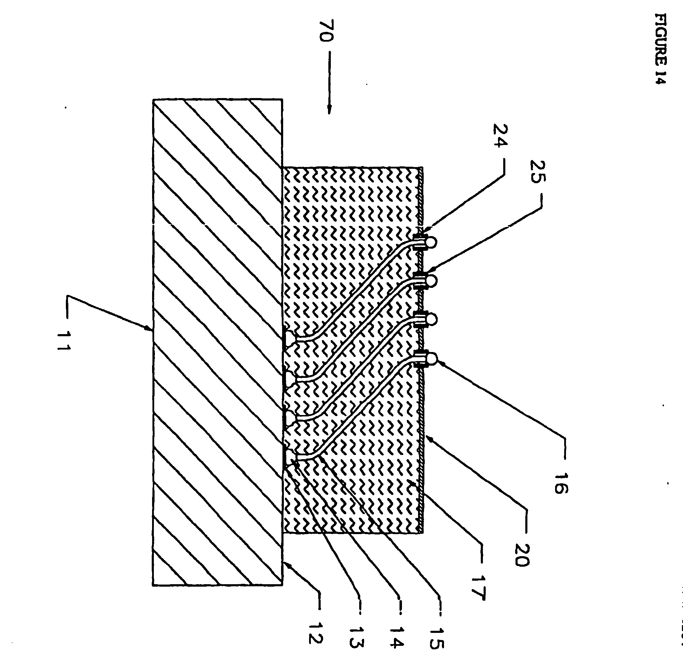

FIGURE 14 shows another example of a test probe (70). The embodiment (70) of the test probe does not use a cantilevered flap and the end of the probe (16) is restricted by the collars (25) surrounding each of the probe wires (15). The collars (25) are positioned below the ball shaped ends of the probe tips (16) to prevent the tips (16) from sinking into the soft elastomer material (17) during compression. The collars (25) sit in separate openings (24) in the sheet (20) and allow vertical movement of the probe tips (16) but restrict lateral movement.

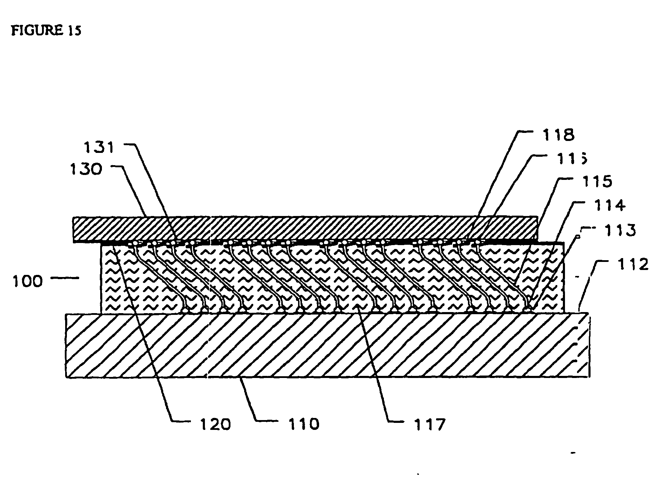

FIGURE 15 shows a cross section of an integrated cantilever compliant test probe array (100) for testing multiple IC devices on a single wafer. The integrated test probe (100) shown in figure 15 includes four distinct probe arrays used to test individual IC devices on the wafer (130). The construction of each distinct probe array is identical to that shown in figure 1, but can be any of the embodiments described herein or in the US patent applications and patents incorporated herein by reference. The substrate (110) used as the base for building the test probe has an array of pads (113) on the top surface (112) that matches the pattern of contacts (131) on the wafer (130) to be tested. The test probes are bonded to these pads (113) and formed at an angle or other suitable shape as described in the FIGURES 3 to 6 and 17. The angle or shape of the bond wires (115) are preferably all be the same to ensure accurate positioning of the ball shaped contact (116) on the end of the probe. Likewise, the geometry of the cantilevered sections (118) of the top polymer sheet (120) must be identical to ensure accurate alignment and uniform wiping against the mating contact pads (131) on the wafer (130). Uniform material properties and height of the elastomer material (117) are necessary to provide optimum compliance and contact normal force across the entire surface of the probe array.

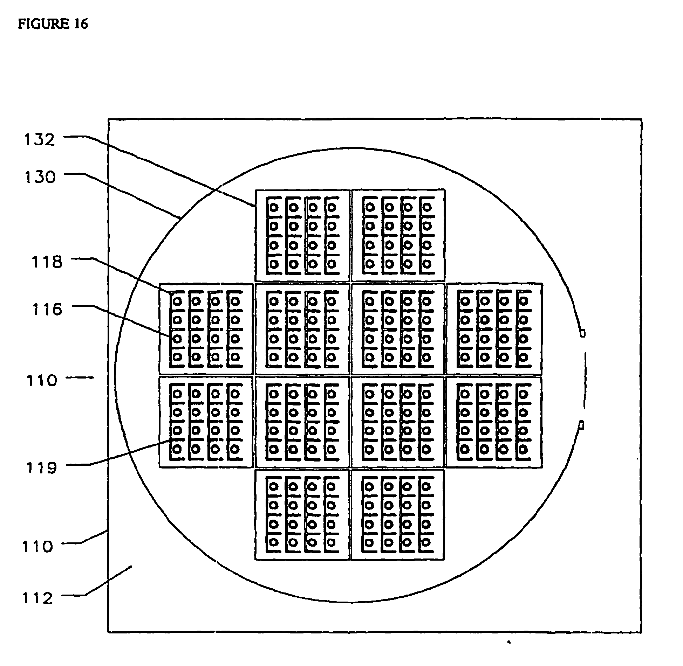

FIGURE 16 shows a top view of an integrated cantilever compliant test probe array (100) for testing all of the IC devices on a single wafer (130). The integrated test probe (100) shown in figure 16 includes twelve distinct probe arrays used to test all of the IC devices on the wafer (130). The outline of the wafer (130) and the individual IC devices (132) are shown with broken or dashed lines. The location of each array of probes corresponds with the pads on each of the individual IC devices (132) on the wafer (130). The location of the ball shaped ends (118) of the test probes is controlled by the location of the opening in the cantilevered sections (118) of the thin polymer sheet (120).

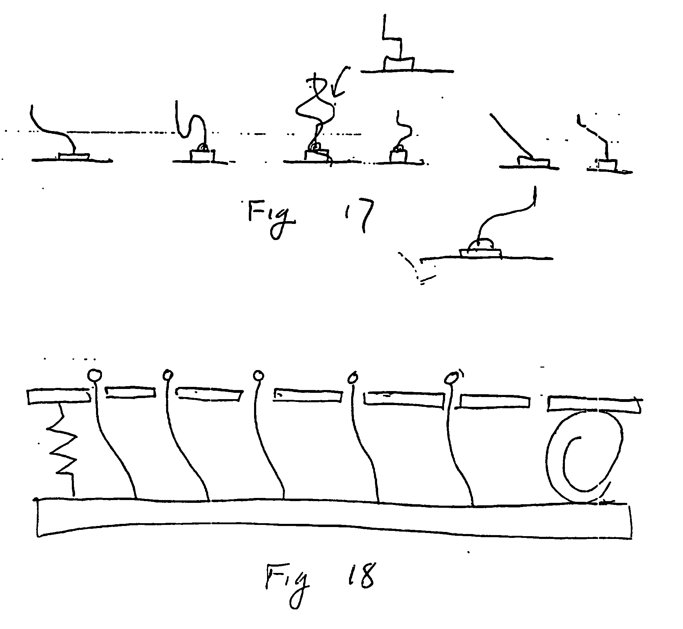

FIGURE 17 schematically shares a variety of shape of probe wires useful to practice the present invention, such as "S" showed "C" shaped, continuously curved, piece wire curved, piece wire linear and combinations thereof.

FIGURE 18 schematically shows alternative embodiments of compliant frame structures (17) to support probe tip positioning structure (20) to be maintaining in position and to move as the probe tip ends (16) move when they are moved into engagement with electronic device pads (31).

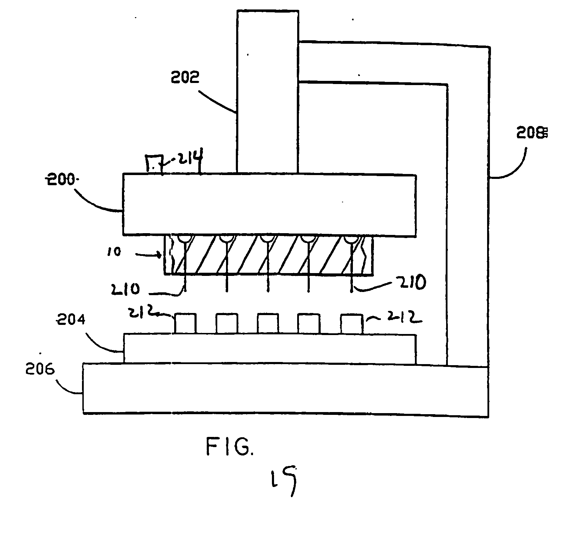

FIGURE 19 schematically shows an apparatus for moving probe structure 10 towards and away from electronic device 204 so that probe tips 210 engage and disengage electrical contact locations 212 on electronic device 204. Probe 10 is mounted on to holder 200 having means 214 for applying electric power to the probe tips 210. Electronic device 206 is held on base 206. Holder 200 is physically connected to support 202 which is converted to arm 208 which is converted to base 206. Support 202 is adapted for up and down movement. Examples of an apparatus to provide the means for support and up and down movement can be found in US Patent 5.439,161 and US Patent 5,132,613.

Co-pending applications are :
U.S. Patent 5,371,654 entitled, "THREE DIMENSIONAL HIGH PERFORMANCE INTERCONNECTION PACKAGE"; U.S. Patent Application Serial No. 08/614,417 entitled, "HIGH DENSITY CANTILEVERED PROBE FOR ELECTRONIC DEVICES";
U.S. Patent Application Serial No. 08/641,667 entitled, "HIGH DENSITY TEST PROBE WITH RIGID SURFACE STRUCTURE"; U.S. Patent Application Serial No. 08/527,733 entitled, "INTERCONNECTOR WITH CONTACT PADS HAVING ENHANCED CURABILITY";
U.S. Patent Application Serial No. 08/752,469 entitled, "FOAMED ELASTOMERS FOR WAFER PROBING APPLICATIONS AND INTERPOSER CONNECTORS";
U.S. Patent Application Serial No. 08/744,903 entitled, "INTEGRAL RIGID CHIP TEST PROBE"; U.S. Patent Application Serial No. 08/756,831 entitled, "HIGHTEMPERATURE CHIP TEST PROBE";
U.S. Patent Application Serial No. 08/756,830 entitled, "A HIGH DENSITY INTEGRAL TEST PROBE AND FABRICATION METHOD"; U.S. Patent Application Serial No. 08/754,869 entitled, "HIGH DENSITY INTEGRATED CIRCUIT APPARATUS, TEST PROBE AND METHODS OF USE THEREOF".

It is to be understood that the above described embodiments are simply illustrative of the principles of the invention. Various other modifications and changes may be devices by those of skill in the art which will embody the principles of the invention as defined in the Claims and fall within the scope thereof.

Several aspects are summarised in clause form below which do not define Claims.

Clause 1 discloses a structure comprising: a substrate having a surface; a plurality of elongated electrical conductors extending away from said surface; each of said elongated electrical conductors having a first end affixed to said surface and a second end projecting away from said surface; there being a plurality of said second ends; a means for permitting each of said plurality of said second ends to move about reference positions; said means for permitting is a sheet of material having a plurality of through-holes therein through which second ends project, there being a perforation in said sheet in the vicinity of said openings.

Clause 2 discloses a structure according to Clause 1 wherein said first end is affixed to said surface at an electrical contact location.

Clause 3 discloses a structure according to clause 1 wherein said sheet is rigid.

Clause 4 discloses a structure according to Clause 1 wherein said perforation comprises a plurality of independent perforations about each of said through-hole.

Clause 5 discloses a structure according to Clause 1 wherein said perforation comprises a plurality of interconnected perforations about at least a part of said plurality of through-holes.

Clause 6 discloses a structure according to Clause 1 wherein said perforation is a portion coupled to an adjacent through-hole.

Clause 7 discloses a structure according to Clause 1 wherein said perforation is adjacent to a plurality of said through-holes.

Clause 8 discloses a structure according to Clause 1 wherein said perforations form a cantilevered flap about at least one of said through-holes.

Clause 9 discloses a structure according to Clause 1 wherein said perforations form a cantilevered flap about more than one of said through-holes.

Clause 10 discloses a structure according to Clause 1 wherein at said second end there is disposed a structure selected from the group consisting of a protuberance and a sharp spike.

Clause 11 discloses a structure according to Clause 1 wherein said sheet is formed from a material selected from the group consisting of a rigid material and a compliant material.

Clause 12 discloses a structure according to Clause 1 wherein said sheet comprises a sheet of electrically conductive material having a plurality of through-holes therein, said sheet of material contains a dielectric material to provide a means for preventing said elongated electrical conductors from electrically contacting said sheet of electrically conductive material.

Clause 13 discloses a structure according to Clause 1 wherein said sheet is spaced apart from said surface by a flexible support.

Clause 14 discloses a structure according to Clause 1 wherein said flexible support is selected from the group consisting of a spring and an elastomeric material.

Clause 15 discloses a structure according to Clause 1 wherein said elongated electrical conductors have a shape selected from the group consisting of linear, piece wise linear, curved and combinations thereof.

Clause 16 discloses a structure according to Clause 13 wherein said sheet and said flexible support form a space containing said plurality of elongated electrical conductors.

Clause 17 discloses a structure according to Clause 16 wherein said space is filled with a flexible material.

Clause 18 discloses a structure according to Clause 17 wherein said flexible material is an elastomeric material.

Clause 19 discloses a structure according to Clause 12 wherein said sheet has a top surface and a bottom surface and said through-holes have a sidewall, said dielectric material coats said top surface and said bottom surface and said sidewall.

Clause 20 discloses a structure according to Clause 1 wherein said plurality of elongated electrical conductors are distributed into a plurality of groups.

Clause 21 discloses a structure according to Clause 21 wherein said plurality of groups are arranged in an array.

Clause 22 discloses a structure according to Clause 1 wherein said structure is a probe for an electronic device.

Clause 23 discloses a structure according to Clause 22 wherein said electronic device is selected from the group consisting of an integrated circuit chip and a packaging substrate.

Clause 24 discloses a structure according to Clause 21 wherein each of said groups corresponds to an integrated circuit chip on a substrate containing a plurality of said integrated circuit chips.

Clause 25 discloses a structure according to Clause 24 wherein said substrate containing said plurality of integrated circuit chips is a wafer of said integrated circuit chips.

Clause 26 discloses an apparatus for using said structure of Clause 1 to test an electronic device comprising: means for holding said structure of Clause 1, means for retractable moving said structure of Clause 1 towards and away from said electronic device so that said second ends contact electrical contact locations on said electronic device, and means for applying electrical signals to said elongated electrical conductors.

Clause 27 discloses a structure according to Clause 10 wherein said protuberance is spherelike.

Clause 28 discloses a structure according to Clause 3 wherein said sheet comprises a sheet of electrically conductive material having a plurality of first through-holes therein, and a sheet of a dielectric material having a plurality of second through-holes therein, said first through-holes are aligned with said second through-holes, said first through-holes having a smaller diameter than said second; through-holes to provide a means for preventing said elongated electrical conductors from electrically contacting said sheet of electrically conductive material.

Clause 29 discloses a structure according to Clause 28 wherein sheet or electrically conductive material has a first side and a second side, said sheet of dielectric material is disposed on either of said first side and said second side of said sheet of electrically conductive material.

Clause 30 discloses a structure according to Clause 29 where there is disposed on said first side and said second side of said sheet of electrically conductive material a layer of said dielectric material.

Clause 31 discloses a structure according to Clause 3 wherein said sheet comprises a sheet of rigid material having a plurality of through-holes therein, said sheet contains a dielectric material to provide a means for preventing said elongated electrical conductors from electrically contacting said sheet of electrically conductive material.

Clause 32 discloses a structure according to Clause 3 wherein said sheet comprises a sheet of dielectrical material having a plurality of through-holes therein, said sheet contains a sheet of a rigid material disposed in contact with said sheet of dielectric material, said sheet of rigid material has an opening therein exposing a plurality of said through-holes to provide a means for support of said dielectric material.

Clause 33 discloses a structure according to Clause 31 wherein said sheet is spaced apart from said surface by a flexible support, said sheet of rigid material is disposed on said flexible support.

Clause 34 discloses an apparatus for making electrical contact with a plurality of bond pads on an integrated circuit device comprising: a first fan out substrate having a first surface; said first surface having a plurality of contact locations; a plurality of ball bonds attached to said plurality of contact locations; a plurality of wires extending outward from said ball bonds, away from said first surface on fan out substrate;a plurality of ball shaped contacts on the ends of said plurality of wires; a means for permitting each of said plurality of ball shaped contact locations to move about corresponding reference positions; said fan out substrate is selected from the group consisting, of: multilayer ceramic substrates with thick film wiring; multilayer ceramic substrates with thin film wiring; metallized ceramic substrates with thin film wiring; epoxy glass laminate substrates with copper wiring; silicon substrates with thin film wiring.

Clause 35 discloses an apparatus according to Clause 34 wherein said apparatus is a probe for simultaneously contacting a plurality of integrated circuits.

Clause 36 discloses an apparatus according to Clause 34, further including a preformed frame of foamed elastomer material surrounding clusters, groupings, or arrays of said wires.

Clause 37 discloses an apparatus according to Clause 36, further including a layer of elastomer material surrounding said probes in said cluster.

Clause 38 discloses an apparatus according to Clause 37, further including a sheet of Invar material that has a thin coating of a polymer material and a plurality of openings corresponding to said plurality of ball shaped contacts.

Clause 39 discloses an apparatus according to Clause 37, further including a sheet of Invar material with a plurality of large diameter openings corresponding to said plurality of ball shaped contacts.

Clause 40 discloses an apparatus according to Clause 37, further including a sheet of polymer material with a plurality of small diameter openings corresponding to said plurality of ball shaped contacts placed on top of said sheet of Invar material.

Clause 41 discloses an apparatus according to Clause 37, further including a sheet of polymer material with a plurality of openings corresponding to said plurality of ball shaped contacts.

Clause 42 discloses an apparatus according to Clause 41, further including a frame of Invar material attached to said sheet of polymer material with said plurality of openings corresponding to said plurality of ball shaped contacts.

Clause 43 discloses an apparatus according to Clause 38, further including a thick frame of Invar material attached to said sheet of Invar material with said thin coating of a polymer material and said plurality of openings corresponding to said plurality of ball shaped contacts.

Clause 44 discloses an apparatus according to Clause 39, further including a plurality of probes arrays corresponding to the location of a plurality of IC devices on a wafer.

Clause 45 discloses an apparatus according to Clause 36, further including a sheet of Invar material that has a thin coating of polymer material and a plurality of openings corresponding to said plurality of ball shaped contacts.

Clause 46 discloses a method comprising: providing a substrate having a surface; forming a plurality of elongated electrical conductors extending away from said surface; each of said elongated electrical conductors having a first end affixed to said surface and a second ending projecting away from said surface; there being a plurality of said second ends; providing a means for permitting each of said plurality of said second ends to move about reference positions; and including moving said second ends into contact with a workpiece, said second ends moving about said reference positions.

Clause 47 discloses a structure according to Clause 1 wherein said sheet is formed and material selected from the group consisting of Invar, Cu/Invar/Cu, molybdenum, polyimides.

Clause 48 discloses a structure according to Clause 1 wherein said sheet is formed from a material selected from the group consisting of a metal, a polymer, a semiconductor and dielectric.

Clause 49 discloses a structure according to Clause 42 wherein said dielectric is selected from the group consisting of a ceramic and a glass.

Clause 50 discloses an apparatus for making electrical contact with a plurality of aluminium bond pads on an integrated circuit device comprising: a first fan out substrate having a first surface; said first surface having a plurality of contact locations; a plurality of ball bonds attached to said plurality of contact locations;a plurality of wires extending outward from said ball bonds, away from said first surface on fan out substrate; a plurality of ball shaped contacts on the ends of said plurality of wires.

Clause 51 discloses a high density probe according to Clause 1, wherein said fan out substrate type includes but is not limited to the following: multilayer ceramic substrates with thick film wiring multilayer ceramic substrates with thin film wiring metallized ceramic substrates with thin film wiring epoxy glass laminate substrates with copper wiring silicon substrates with thin film wiring.

Clause 52 discloses a structure according to Clause 1, further including a layer of elastomer material surrounding said elongated electrical conductors.

Clause 53 discloses a structure according to Clause 1, further including a sheet of polymer material with a plurality of cantilever flaps and openings corresponding to said plurality of ball shaped contacts.

Clause 54 discloses a structure according to Clause 4, further including an epoxy material used to bond the plurality of ball shaped contacts to the corresponding openings in the cantilever flaps.

Clause 55 discloses a structure according to Clause 5, wherein the action of mating the plurality of probes to the plurality of flat or recessed contacts on the IC device causes said plurality of bass shaped contacts to wipe against the IC contacts.

Clause 56 discloses a structure according to Clause 1, further including a plurality of cylindrical collars concentrically located on the plurality of elongated electrical conductors and positioned between the top surface of said elastomer material and the ball shaped contact on the end of said probe wires.

Clause 57 discloses a structure according to Clause 56, further including a sheet of polymer material with a plurality of openings corresponding to said plurality of cylindrical collars concentrically located on the plurality of probe wires.

Clause 58 discloses a structure according to Clause 6, further including a plurality of probes arrays corresponding to the location of a plurality of IC devices on a wafer.

Clause 59 discloses a structure according to Clause 1 wherein said means for permitting is a sheet of material having a plurality of openings therein through which said second ends project.

Clause 60 discloses a method according to Clause 46 wherein said means for permitting is a sheet of material having a plurality of through-holes therein through which said second ends project, there being a perforation in said sheet in the vicinity of said openings.

## Claims

1. A structure (10) comprising:
a substrate (11) having a surface;
a plurality of elongated electrical conductors (15) extending away from said surface (12);
each of said elongated electrical conductors (15) having a first end (14) affixed to said surface and a second end (16) projecting away from said surface;
a sheet of material (20) having a plurality of through-holes therein through which said second ends project;
at least one cantilever flap (23) in the sheet of material (20) formed by a plurality of interconnected perforations, **characterised by :** each cantilever flap (23) having at least one through-hole therein through which a second end projects for movement about a reference position.

2. A structure according to claim 1 wherein said sheet (20) comprises a layer of electrically conductive material and a layer of a dielectric material preventing the second end of said elongated electrical conductors from contacting said layer of electrically conductive material.

3. A structure according to claim 2 wherein said layer of electrically conductive material having a plurality of first through holes therein, and said layer of a dielectric material having a plurality of second throughholes therein, said first through holes are aligned with said secondthrough holes, said firstthrough holes have a smaller diameter than said second throughholes .

4. A structure according to claim 3 wherein said layer of electrically conductive material has a first side and a second side, said layer of dielectric material is disposed on either of said first side and said second side of said layer of electrically conductive material.

5. A structure according to claim 4, where there is disposed on said first side and said second side of said layer of electrically conductive material a layer of said dielectric material.

6. A structure according to claim 1 wherein said sheet comprises a layer of rigid material, said sheet contains a dielectric material to prevent said elongated electrical conductors from electrically contacting said sheet of electrically conductive material.

7. A structure according to claim 1 wherein said sheet comprises a sheet of dielectric material having said through holes therein, said sheet contains a layer of a rigid material disposed in contact with dielectric material, said layer of rigid material has on opening therein exposing a plurality or said throughholes to provide a means for support of said dielectric material.

8. An apparatus for making electrical contact with a plurality of bond pads on an integrated circuit device comprising:
a first fan out substrate (11) having a first surface;
said first surface having a plurality of contact locations; a plurality of ball bonds attached to said plurality of contact locations;
plurality of wires (15) extending outward from said ball bonds, away from said first surface on fan out substrate;
a plurality of ball shaped contacts (16) on the ends of said plurality of wires;
a sheet of material (20) having a plurality of through-holes therein through which said second ends project;
**characterised by**;
at least one cantilever flap (23) in the sheet of material (20) formed by a plurality of interconnected perforations, each cantilever flap (23) having at least one through-hole therein through which a second end projects for movement about a reference position

9. An apparatus as claimed in claim 8 whereby;
said fan out substrate is selected from the group consisting of:
multilayer ceramic substrates with thick film wiring;
multilayer ceramic substrates with thin film wiring;
metallized ceramic substrates with thin film wiring;
epoxy glass laminate substrates with copper wiring;
silicon substrates with thin film wiring.

10. A method comprising:
providing a substrate (11) having a surface;
forming a plurality of elongated electrical conductors (15) extending away from said surface (12);
each of said elongated electrical conductors (15) having a first end (14) affixed to said surface and a second end (16) projecting away from said surface;
there being a plurality of said second ends;
forming a sheet of material (20) having a plurality of through-holes therein through which said second ends project;
providing at least one cantilever flap (23) in the sheet of material (20) formed by a plurality of inter connected perforations, **characterised by :** each cantilever flap (23) having at least one through-hole therein through which a second end projects for movement about a reference position; and
including moving said second ends into contact with a workpiece, said second ends moving about said reference positions.

## Patentansprüche

1. Struktur (10), welche das Folgende umfasst:
ein Substrat (11), welches eine Fläche aufweist;
mehrere längliche elektrische Leiter (15), welche sich von der Fläche (12) weg erstrecken;
wobei jeder der länglichen elektrischen Leiter (15) ein erstes Ende (14), welches an der Fläche befestigt ist, und ein zweites Ende (16) aufweist, welches von der Fläche weg ragt;
ein Blatt eines Materials (20), in welchem sich mehrere Durchtrittsöffnungen befinden, durch welche die zweiten Enden hindurch ragen;
mindestens eine einseitig befestigte Klappe (23) in dem Blatt des Materials (20), welche durch mehrere miteinander verbundene Perforationen gebildet wird, **dadurch gekennzeichnet, dass** sich in jeder einseitig befestigten Klappe (23) mindestens eine Durchtrittsöffnung befindet, durch welche ein zweites Ende hindurch ragt, um sich um eine Referenzposition herum zu bewegen.

2. Struktur nach Anspruch 1, wobei das Blatt (20) eine Schicht eines elektrisch leitfähigen Materials und eine Schicht eines dielektrischen Materials umfasst, wodurch verhindert wird, dass das zweite Ende der länglichen elektrischen Leiter mit der Schicht des elektrisch leitfähigen Materials in Kontakt gerät.

3. Struktur nach Anspruch 2, wobei sich in der Schicht des elektrisch leitfähigen Materials mehrere erste Durchtrittsöffnungen befinden und in der Schicht des dielektrischen Materials mehrere zweite Durchtrittsöffnungen befinden, wobei die ersten Durchtrittsöffnungen mit den zweiten Durchtrittsöffnungen in Ausrichtung gebracht sind, und wobei die ersten Durchtrittsöffnungen einen kleineren Durchmesser als die zweiten Durchtrittsöffnungen aufweisen.

4. Struktur nach Anspruch 3, wobei die Schicht des elektrisch leitfähigen Materials eine erste Seite und eine zweite Seite aufweist und die Schicht des dielektrischen Materials an der ersten Seite oder an der zweiten Seite der Schicht des elektrisch leitfähigen Materials angeordnet ist.

5. Struktur nach Anspruch 4, wobei an der ersten Seite und an der zweiten Seite der Schicht des elektrisch leitfähigen Materials eine Schicht des dielektrischen Materials angeordnet ist.

6. Struktur nach Anspruch 1, wobei das Blatt eine Schicht eines steifen Materials umfasst, wobei das Blatt ein dielektrisches Material enthält, um zu verhindern, dass die länglichen elektrischen Leiter mit dem Blatt des elektrisch leitfähigen Materials in elektrischen Kontakt geraten.

7. Struktur nach Anspruch 1, wobei das Blatt ein Blatt eines dielektrischen Materials mit den darin befindlichen Durchtrittsöffnungen umfasst, das Blatt eine Schicht eines steifen Materials enthält, welche in Kontakt mit dem dielektrischen Material angeordnet ist, und die Schicht des steifen Materials eine Öffnung aufweist, welche mehrere der Durchtrittsöffnungen frei legt, um ein Mittel zum Halten des dielektrischen Materials bereitzustellen.

8. Vorrichtung zur Herstellung eines elektrischen Kontakts mit mehreren Kontaktflecken auf einem Bauelement einer integrierten Schaltung, wobei die Vorrichtung das Folgende umfasst:
ein erstes Ausgangssubstrat (11), welches eine erste Fläche aufweist;
wobei die erste Fläche mehrere Kontaktstellen aufweist;
wobei mehrere Kugelkontakte an den mehreren Kontaktstellen angebracht sind;
mehrere Drähte (15), welche sich von den Kugelkontakten aus nach außen, von der ersten Fläche auf dem Ausgangssubstrat weg, erstrecken;
mehrere kugelförmige Kontakte (16) an den Enden der mehreren Drähte;
ein Blatt eines Materials (20), in welchem sich mehrere Durchtrittsöffnungen befinden, durch welche die zweiten Enden ragen;
**gekennzeichnet durch**:
mindestens eine einseitig befestigte Klappe (23) in dem Blatt des Materials (20), welche **durch** mehrere miteinander verbundene Perforationen gebildet wird, wobei sich in jeder einseitig befestigten Klappe (23)
mindestens eine Durchtrittsöffnung befindet, **durch** welche ein zweites Ende hindurch ragt, um sich um eine Referenzposition herum zu bewegen.

9. Vorrichtung nach Anspruch 8, wobei:
das Ausgangssubstrat aus der Gruppe ausgewählt ist, die aus dem Folgenden besteht:
mehrschichtige Keramiksubstrate mit Dickschichtverdrahtung;
mehrschichtige Keramiksubstrate mit Dünnschichtverdrahtung;
metallisierte Keramiksubstrate mit Dünnschichtverdrahtung;
Epoxidglaslaminat-Substrate mit Kupferverdrahtung;
Siliciumsubstrate mit Dünnschichtverdrahtung.

10. Verfahren, welches das Folgende umfasst:
Bereitstellen eines Substrats (11), welches eine Fläche aufweist;
Bilden mehrerer länglicher elektrischer Leiter (15), welche sich von der Fläche (12) weg erstrecken;
wobei jeder der länglichen elektrischen Leiter (15) ein erstes Ende (14), welches an der Fläche befestigt ist, und ein zweites Ende (16) aufweist, welches von der Fläche weg ragt;
wobei es mehrere der zweiten Enden gibt;
Bilden eines Blatts eines Materials (20), in welchem sich mehrere Durchtrittsöffnungen befinden, durch welche die zweiten Enden hindurch ragen;
Bereitstellen mindestens einer einseitig befestigten Klappe (23) in dem Blatt des Materials (20), welche durch mehrere miteinander verbundene Perforationen gebildet wird, **dadurch gekennzeichnet, dass** sich in jeder einseitig befestigten Klappe (23) mindestens eine Durchtrittsöffnung befindet, durch welche ein zweites Ende hindurch ragt, um sich um eine Referenzposition herum zu bewegen; und
Einbeziehen des Bewegens der zweiten Enden in Kontakt mit einem Werkstück, wobei sich die zweiten Enden um die Referenzpositionen herum bewegen.

## Revendications

1. Structure (10), comprenant:
un substrat (11) ayant une surface ;
une pluralité de conducteurs électriques (15) allongés, s'étendant en s'écartant de ladite surface (12) ;
chacun desdits conducteurs électriques (15) allongés ayant une première extrémité (14) fixée à ladite surface et une deuxième extrémité (16) faisant saillie en s'écartant de ladite surface ;
une feuille de matériau (20), ayant en son sein une pluralité de trous traversants, à travers lesquels lesdites deuxièmes extrémités font saillie ;
au moins un volet en porte-à-faux (23), dans la feuille de matériau (20), formés par une pluralité de perforations interconnectées, **caractérisé par le fait que** chaque volet en porte-à-faux (23) présente en son sein au moins un trou traversant, par lequel une deuxième extrémité fait saillie, pour se déplacer autour d'une position de référence.

2. Structure selon la revendication 1, dans laquelle ladite feuille (23) comprend une couche de matériau conducteur de l'électricité et une couche de matériau diélectrique, empêchant la deuxième extrémité desdits conducteurs électriques allongés d'entrer en contact avec ladite couche de matériau conducteur de l'électricité.

3. Structure selon la revendication 2, dans laquelle ladite couche de matériau conducteur de l'électricité présente en son sein une pluralité de premiers trous traversants, et ladite couche de matériau diélectrique présente en son sein une pluralité de deuxièmes trous traversants, lesdits premiers trous traversants étant alignés avec lesdits deuxièmes trous traversants, lesdits premiers trous traversants ayant un plus petit diamètre que lesdits deuxièmes trous traversants.

4. Structure selon la revendication 3, dans laquelle ladite couche de matériau conducteur de l'électricité présente une première face et une deuxième face, ladite couche de matériau diélectrique étant disposée soit sur ladite première face soit sur ladite deuxième face de ladite couche de matériau conducteur de l'électricité.

5. Structure selon la revendication 4, dans laquelle une couche dudit matériau diélectrique est disposée sur ladite première face et ladite deuxième face de ladite couche de matériau conducteur de l'électricité.

6. Structure selon la revendication 1, dans laquelle ladite feuille comprend une couche de matériau rigide, ladite feuille contient un matériau diélectrique de manière à empêcher que lesdits conducteurs électriques allongés entrent en contact électrique avec ladite feuille de matériau conducteur de l'électricité.

7. Structure selon la revendication 1, dans laquelle ladite feuille comprend une feuille de matériau diélectrique présentant en son sein lesdits trous traversants, ladite feuille contient une couche d'un matériau rigide, disposé en contact avec du matériau diélectrique, ladite couche de matériau rigide présente en son sein une ouverture exposant une pluralité desdits trous traversants, de manière à fournir un moyen de supporter ledit matériau diélectrique.

8. Dispositif d'établissement d'un contact électrique avec une pluralité de plages de contact de liaison sur un dispositif à circuit intégré, comprenant :
un premier substrat de sortance (11), présentant une première surface ;
ladite première surface ayant une pluralité d'emplacements de contact ; une pluralité de liaisons par boule, fixées à ladite pluralité d'emplacements de contact ;
une pluralité de fils (15), s'étendant à l'extérieur desdites liaisons à boule, en s'écartant de ladite première surface sur le substrat de sortance ;
une pluralité de contacts en forme de boule (16), sur les extrémités de ladite pluralité de fils ;
une feuille de matériau (20) ayant en son sein une pluralité de trous traversants, par lesquels lesdites deuxièmes extrémités font saillie ;
**caractérisé par** :
au moins un volet en porte-à-faux (23), dans la feuille de matériau (20), formés par une pluralité de perforations interconnectées, chaque volet en porte-à-faux (23) présentant en son sein au moins un trou traversant, par lequel une deuxième extrémité fait saillie, pour se déplacer autour d'une position de référence.

9. Dispositif selon la revendication 8, dans lequel :
ledit substrat de sortance est sélectionné dans le groupe composé de :
substrats en céramique multicouches avec câblage à film épais ;
substrats en céramique multicouches avec câblage à film mince ;
substrats en céramique métallisés avec câblage à film mince ;
substrats en laminés verre époxy avec câblage en cuivre ;
substrats en silicium avec câblage à film mince.

10. Procédé, comprenant :
la fourniture d'un substrat (11) ayant une surface ;
la formation d'une pluralité de conducteurs électriques (15) allongés, s'étendant en s'écartant de ladite surface (12) ;
chacun desdits conducteurs électriques (15) allongés ayant une première extrémité (14) fixée à ladite surface et une deuxième extrémité (16) faisant saillie en s'écartant de ladite surface ;
lesdits deuxièmes extrémités étant présente en une pluralité ;
la formation d'une feuille de matériau (20), ayant en son sein une pluralité de trous traversants, à travers lesquels lesdites deuxièmes extrémités font saillie ;
la fourniture d'au moins un volet en porte-à-faux (23), dans la feuille de matériau (20), formés par une pluralité de perforations interconnectées, **caractérisé par le fait que** chaque volet en porte-à-faux (23) présente en son sein au moins un trou traversant, par lequel une deuxième extrémité fait saillie, pour se déplacer autour d'une position de référence ; et
incluant le déplacement desdites deuxièmes extrémités pour les mettre en contact avec une pièce d'oeuvre, lesdites deuxièmes extrémités se déplaçant autour desdites positions de référence.
